Europäisches Patentamt

European Patent Office

Office européen des brevets

(19)

(11) Publication number: **0 023 775**
**B1**

(12) **EUROPEAN PATENT SPECIFICATION**

(45) Date of publication of patent specification: **29.06.83**

(51) Int. Cl.³: **H 01 L 21/302**

(21) Application number: **80302336.5**

(22) Date of filing: **10.07.80**

(54) **A method of manufacturing a semiconductor device.**

(30) Priority: **11.07.79 JP 87669/79**

(43) Date of publication of application:
**11.02.81 Bulletin 81/6**

(45) Publication of the grant of the patent:
**29.06.83 Bulletin 83/26**

(84) Designated Contracting States:
**DE FR GB NL**

(56) References cited:
**DE - A - 2 104 671**
**DE - B - 2 517 159**
**US - A - 3 718 514**
**US - H - 563 722**

(73) Proprietor: **FUJITSU LIMITED**
**1015, Kamikodanaka Nakahara-ku**
**Kawasaki-shi Kanagawa 211 (JP)**

(72) Inventor: **Abe, Sigeharu**
**32-1, Yamami-machi Aizuwakamatsu-shi**
**Fukushima, 965 (JP)**
Inventor: **Tamura, Hideo**
**243, Minamiaoki Kuroiwa Monden-machi**
**Aizuwakamatsu-shi Fukushima, 965 (JP)**
Inventor: **Murakami, Takayuki**
**3-2-4-204, Ohji**
**Atsugi-shi Kanagawa, 243 (JP)**

(74) Representative: **Bedggood, Guy Stuart et al,**
**Haseltine Lake & Co. Hazlitt House 28**
**Southampton Buildings Chancery Lane**
**London WC2A 1AT (GB)**

Courier Press, Leamington Spa, England.

A method of manufacturing a semiconductor device

This invention relates to a method of manufacturing a semiconductor device.

For example for forming epitaxial layers on the surfaces of semiconductor substrates, processes for growing layers by chemical vapour deposition techniques (such layers to be called hereafter "vapour-phase-grown layers") are extensively used in the manufacture of semiconductor devices. For instance, chemical vapour deposition techniques are employed for forming silicon nitride membranes used in selectively forming diffused regions or oxidized layers and are also employed for forming polysilicon layers to be used as conductive layers. Thus, chemical vapour deposition techniques are important and at times indispensable.

However, unusual projections, that is convex surface flaws or protrusions of foreign matter are often found on the surfaces of vapour-phase-grown layers on the surfaces of semi-conductor substrates. For example, when an epitaxial layer is grown on a silicon substrate, it is generally observed that the existence of heavy metals such as iron and copper, or of minute particles of silicon causes abnormal projections commonly called "epitaxial rocks", having an average height of several micrometers to appear where such metals or silicon particles are located.

It is difficult to remove such epitaxial rocks even if conventional scrubbers are utilized.

Where a semiconductor chip is formed on a vapour-phase-grown layer with such epitaxial rocks thereon, the surface of a photo-mask used in a photo process can be damaged by scratches caused by the epitaxial rocks. If such a mask is used repeatedly production yield falls exponentially as scratches on the mask surface accumulate. Because of this, efforts have been made to maintain a desired production yield by limiting the frequency of use of a given photo-mask. This, in turn, has necessitated an increase in the number of photo-masks which must be kept in stock, and this is reflected in a sharp rise in manufacturing costs.

Further, where membranes of silicon nitride are formed, convex or projecting protrusions of foreign matter also appear. Such protrosions are difficult to remove. Again in the industry, the number of photomasks held in reserve is increased in order to avoid reduced production yield, but this also raises manufacturing costs.

On the other hand, a method of using an alignment device with a non-contact type mask has been proposed. However, this method involves considerable expense, and manufacturing costs are again increased.

U.S. Patent No. 3,718,514 (Erdman) discloses a method of removing projections from the surface of epitaxially-deposited semiconductor layers. In this method, a discontinuous film is applied to an oxide layer on the surface of an epitaxial layer in such a manner that discontinuities in the film align with the surface projections. Through a series of etching steps carried out thereafter, the projections are selectively removed.

To carry out such a method, however, a discontinuous film must be prepared. There is no assurance that the discontinuities in the film are all aligned with all the projections on the epitaxial layer.

Japanese Patent Publication (Unexamined) No. 121266 published on October 23, 1976, relates to a Japanese Patent Application based on U.S. Patent Application Serial No. 563,722 filed on March 31, 1975. This publication also discloses a method for the removal of projections on epitaxial layers. In this method, a layer of inorganic dielectric material is formed on the surface of an epitaxial layer on a substrate in such a manner that the thickness of the layer is smaller than the average height of some projections on the epitaxial layer. Next, a suitable tool such as a conventional razor blade is used to damage the projections. An etching process is then carried out to etch the projections selectively to finally remove the projections. This method involves delicate and selective damaging of projections, which involves the use of extra human labour and hence increased costs.

Japanese Patent Publication (Unexamined) No. 120272 published on October 20, 1978 discloses a method of removing projections appearing on the surface of a semi-conductor substrate. The method involves a type of evaporation that is termed oblique evaporation; that is, masking material is evaporated at an angle of 10 degrees from the surface of the substrate. By such evaporation, only one side of a surface projection is covered by evaporated masking material. Thereafter, etching is effected, the etching progressing from the side that is not covered by masking material, and thus the projection is selectively removed.

Alternatively, masking material is evaporated perpendicularly to the surface of the substrate. The thickness of material covering a projection is less than that of material covering remaining part of a substrate. By setting etching time properly, material covering the projection can be completely etched while some material still remains on the surface of the remaining part of the substrate. The projection is then etched without affecting the integrity of the remainder of the substrate surface.

It is apparent that oblique evaporation requires a device of considerable complexity. Further, selectively etching only the masking material on a projection without affecting the remaining surface of a substrate would also be difficult—projections are not all of the same size and the extent of etching necessary to provide for this selective etching is indeterminate. To carry out etching to remove projections selectively would be extremely delicate and complex, and should involve additional devices and operations involving extra costs.

According to the present invention there is provided a method of manufacturing a semiconductor device in which a layer is formed on a semiconductor substrate, characterised by the steps of:—

forming a membrane that resists etching on the layer,

Pressing a flat plate against the membrane thereby to rupture the membrane where it covers an unwanted projection or epitaxial rock on the layer, to expose the projection, and

etching the projection.

An embodiment of this invention can overcome problems previously encountered by making the surface of, for example, a vapour-phase-grown layer flat and smooth (i.e. free from convex flaws or projections). More particularly, the removal of projections or epitaxial rocks is accomplished by means of a flat glass plate or other suitable flat plate used to rupture those parts of a membrane of, for example, plastics material provided over the projections. After removal of those parts of the membrane on the projections, ruptured by contact with the flat plate, the projections are selectively etched and removed.

Thus, briefly, embodiments of the present invention provide for the surface treatment of a layer on a semiconductor substrate for removal of projections by a method comprising forming a membrane of material (e.g. plastics material) that resists etching on the surface of the layer, rupturing and removing membrane parts covering foreign matter or projections on the layer by pressing a plate having parallel surfaces against the membrane to expose such projections, and finally removing the projections selectively by etching.

Reference is made, by way of example, to the accompanying drawing, in which

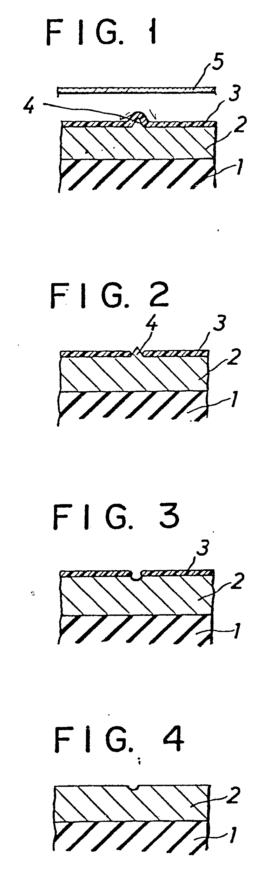

Figures 1 to 4 are schematic cross-sectional views illustrating respective steps in a method embodying this invention.

In a method embodying the present invention as illustrated in the Figures, photo-resist is applied by a conventional spinner onto an epitaxial layer 2 deposited on a semiconductor substrate 1. After pre-baking the substrate thus worked on, a resist membrane 3 of a thickness of approximately 1 micrometer is formed as illustrated in Fig. 1. The membrane 3 covers a convex projection or epitaxial rock 4 of some foreign matter or of a silicon particle appearing on the epitaxial layer 2.

The semiconductor substrate 1 is next placed in position in a conventional contact type mask alignment device. A suitable glass plate 5 having a flat and smooth surface is pressed from above against the resist membrane 3 and then lifted. This pressing and lifting operation is carried out several times until the resist membrane covering the epitaxial rock 4 is ruptured, exposing the epitaxial rock 4 as shown in Fig. 2.

Then, the semiconductor 1 that has been worked as described above is baked in a known manner at about 100°C and placed into a conventional plasma etching device to carry out plasma etching using carbon tetrafluoride ($CF_4$) gas such that only the epitaxial rock 4 is etched and removed as shown in Fig. 3.

Thereafter, the resist membrane 3 is dissolved by the use of an organic solvent and thereby removed until the convex projection 4 of foreign matter; vanishes from the epitaxial layer 2 to present an epitaxial layer that has a flat and smooth surface (i.e. a surface free from the convex flaws or projections) as shown in Fig. 4.

Where surface treatment was carried out as described above, there were 3.2 defects per 1 $cm^2$ on the surface of an epitaxial layer from which epitaxial rocks had been removed by a method embodying the present invention. This compares with an average of 7.2 defects per 1 $cm^2$ on the surface of an epitaxial layer from which epitaxial rocks were not removed as seen in a conventional technique. Thus, the present invention lead to a substantial improvement in surface condition.

Convex projections of foreign matter appearing when a layer of silicon nitride is formed also consist essentially of silicon compounds, so that it is also possible to remove such projections in a manner described above.

The embodiment described above involves a process wherein photoresist is applied to a substrate which then is set in a mask alignment device with a view to rupturing the resist membrane on a surface projection or epitaxial rock. However, the present invention is not restricted to the use of photoresist membranes; to cover epitaxial rocks any other membrane that can resist etching and that is capable of being ruptured may alternatively be used.

The plate that is pressed against the membrane (e.g. the resist membrane) need not be a glass mask, but may be any other plate having a surface of a high degree of flatness.

Further the etching step does not necessarily involve plasma etching. Projections of foreign matters may be removed by immersing the projections in an etching solution.

As has been described, a method of embodying the present invention, a membrane (for example a plastic membrane) is formed, mechanical contacts with the membrane are effected, then the projections or epitaxial rocks of foreign matter are removed by etching. These steps can easily be performed and whatever increase in cost is necessitated by these steps is amply compensated by the decreased number of masks required for stock, since masks are expensive. Thus, the use of embodiments of the present invention can serve to reduce the cost of manufacturing semiconductor devices.

Therefore, the use of embodiments of the present invention can serve in raising the product yield and cutting down the manufacturing cost involved in the making of semiconductor devices.

The problem of epitaxial rocks arises not only in connection with layers formed by chemical vapour deposition techniques but also in connection with layers formed by liquid phase epitaxy techniques or by ion beam epitaxy techniques for example. The present invention can be employed for the removal of epitaxial rocks from layers formed by any of the above techniques.

Thus, a method of manufacturing a semiconductor device embodying this invention provides for surface treatment of a layer grown on a semiconductor substrate by a chemical vapour deposition technique for removing projections appearing on the layer. The method comprises the steps of: forming a layer on a semiconductor substrate by a chemical vapour deposition technique for example, forming a membrane of plastic material, for example, that resists etching on the layer, pressing a flat plate against the plastic membrane on a projection of the layer to expose the projection, and etching the projection.

## Claims

1. A method of manufacturing a semiconductor device in which a layer (2) is formed on a semiconductor substrate (1), characterised by the steps of:—

forming a membrane (3) that resists etching on the layer (2),
pressing a flat plate (5) against the membrane (3) thereby to rupture the membrane only where it covers an unwanted projection (4) or epitaxial rock on the layer, to expose the projection, and
etching the projection (4).

2. A method as claimed in claim 1, wherein the membrane (3) is of photo-resist.

3. A method as claimed in claim 1 or 2, wherein the flat plate (5) is a flat glass plate.

4. A method as claimed in claim 1, 2 or 3, wherein the projection (4) is etched by plasma etching.

5. A method as claimed in claim 1, 2 or 3, wherein the projection (4) is etched by immersion in an etching solution.

6. A method as claimed in claim 1, wherein the membrane (3) is a plastic membrane.

7. A method as claimed in any preceding claim, in which the layer (2) is formed by chemical vapour deposition.

## Revendications

1. Procédé de fabrication d'un dispositif semiconducteur dans lequel une couche (2) est formée sur un substrat semiconducteur (1), caractérisé par les opérations suivantes:

— former sur la couche (2) une membrane (3) qui résiste à l'attaque,
— appliquer une plaque plane (5) contre la membrane (3) de manière à rompre la membrane là seulement où elle recouvre une partie saillante non voule (4), ou bloc épitaxial, sur la couche, afin de mettre à nu la partie saillante, et
— attaquer la partie saillante (4).

2. Procédé selon la revendication 1, où la membrane (3) est en vernis photorésistant.

3. Procédé selon la revendication 1 ou 2, où la plaque plane (5) est une plaque de verre plane.

4. Procédé selon la revendication 1, 2 ou 3, où on attaque la partie saillante (4) au moyen d'une attaque par plasma.

5. Procédé selon la revendication 1, 2 ou 3, où on attaque la partie saillante (4) par immersion dans une solution d'attaque.

6. Procédé selon la revendication 1, où la membrane (3) est une membrane de matière plastique.

7. Procédé selon l'une quelconque des revendications précédentes, dans lequel on forme la couche (2) par dépôt en vapeur chimique.

## Patentansprüche

1. Verfahren zur Herstellung einer Halbleitervorrichtung, bei welcher eine Schicht (2) auf einem Halbleitersubstrat (1) ausgebildet wird, dadurch gekennzeichnet, daß eine Membrane (3), welche gegen Ätzung widerstandsfähig ist, auf der Schicht (2) ausgebildet wird, daß eine flache Platte (5) gegen die Membrane (3) gepreßt wird, um die Membrane nur dort, wo sie einen unerwünschten Vorsprung (4) oder epitaxialen Stein auf der Schicht überdeckt, zu durchbrechen wird, um den Vorsprung zu exponieren, und daß der Vorsprung (4) geätzt wird.

2. Verfahren nach Anspruch 1, dadurch gekennzeichnet, daß die Membrane (3) ein Fotoresist ist.

3. Verfahren nach Anspruch 1 oder 2, dadurch gekennzeichnet, daß die flache Platte (5) eine flache Glasplatte ist.

4. Verfahren nach einem der Ansprüche 1, 2 oder 3, dadurch gekennzeichnet, daß der Vorsprung (4) durch Plasma-Ätzung weggeätzt wird.

5. Verfahren nach einem der Ansprüche 1, 2 oder 3, dadurch gekennzeichnet, daß der Vorsprung (4) durch Immersion in einer Ätzflüssigkeit weggeätzt wird.

6. Verfahren nach Anspruch 1, dadurch gekennzeichnet, daß die Membrane (3) eine Plastikmembrane ist.

7. Verfahren nach einem der vorheregehenden Ansprüche, dadurch gekennzeichnet, daß die Schicht (2) durch chemische Dampfdeposition gebildet wird.

# F I G. 1

# F I G. 2

# F I G. 3

# F I G. 4